# EUROPEAN PATENT SPECIFICATION

(11) **EP 0 588 142 B1**
(45) Date of publication and mention of the grant of the patent: **04.12.1996**
(21) Application number: 93113859.8
(22) Date of filing: 30.08.1993
(51) Int. Cl.: H03K 7/08

(54) **Signal integration circuit**
Signal Integrierschaltung
Circuit d'intégration

(30) Priority: 11.09.1992 JP 269244/92
(43) Date of publication of application: 23.03.1994
(73) Proprietor: YOZAN INC., Tokyo 155 (JP); SHARP KABUSHIKI KAISHA, Osaka 545 (JP)
(72) Inventor: Shou, Guoliang, Setagay-ku, Tokyo 155 (JP); Yamamoto, Makoto, Setagay-ku, Tokyo 155 (JP); Takatori, Sunao, Setagay-ku, Tokyo 155 (JP)
(74) Representative: Grünecker, Kinkeldey, Stockmair & Schwanhäusser Anwaltssozietät

(56) References cited:
- WO-A-89/00739
- PATENT ABSTRACTS OF JAPAN vol. 13, no. 201 (E-757)12 May 1989 & JP-A-01 020 788
- SOVIET INVENTIONS ILLUSTRATED Section EI, Week 8548, 23 May 1985 Derwent Publications Ltd., London, GB; Class U22, AN 85-301827 & SU-A-1 157 677
- PATENT ABSTRACTS OF JAPAN vol. 4, no. 67 (E-011)20 May 1980 & JP-A-55 034 593

## Description

### FIELD OF THE INVENTION

The present invention relates to a signal integration circuit effective for weighted integration of signals.

### BACKGROUND OF THE INVENTION

Conventionally, it has been necessary a device comprising a plural number of input to integrate signals, and also necessary a device with a plural number of inputs and different type of devices or libraries corresponding to the number of inputs. Generally a multiplication circuit has been necessary for giving weight and integrating each signal. Realizing it, the structure of the circuit has been complex.

### SUMMARY OF THE INVENTION

The present invention solves the above conventional problems and has an object to provide a signal integration circuit for integrating a weighted signal by a simple circuit.

A signal integration circuit according to the present invention controls the threshold of MOSFET by voltage integrated by giving an electrical charge to a parallel capacitance, and generates an output pulse signal by eliminating referential saw-tooth signal with the threshold. Each capacitance is charged by connecting the power source comprising the predetermined voltage to the capacitance synchronous to the input pulse signal.

### BRIEF DESCRIPTION OF THE DRAWINGS

Figure 1 shows a circuit embodied the signal integration circuit according to the present invention.

Figure 2 shows a circuit of an input module of the embodiment in Figure 1.

Figure 3 (a) shows a graph of the relationship between input pulse signal and input module output.

Figure 3 (b) shows a graph of the relationship between the referential saw-tooth wave form and threshold voltage.

Figure 3 (c) shows a graph of the relationship between the referential saw-tooth wave form and output pulse signal.

### PREFERRED EMBODIMENT OF THE PRESENT INVENTION

Hereinafter an embodiment of the signal integration circuit according to the present invention is described with reference to the attached drawings.

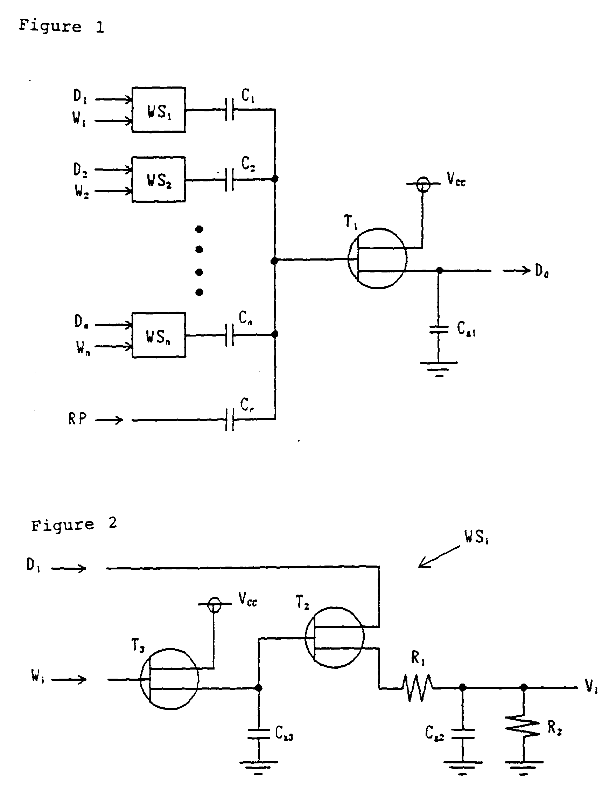

In Figure 1, the signal integration circuit connects a plural number of input modules WS1, WS2, ..., WSn to MOSFET ("T1", hereinafter) through parallel capacitances C1, C2, ..., Cn. The drain of T1 is connected to input power source Vcc. The source of T1 is grounded through capacitance Cg1. Voltage Do is generated in the source of T1 according to the voltage of the gate.

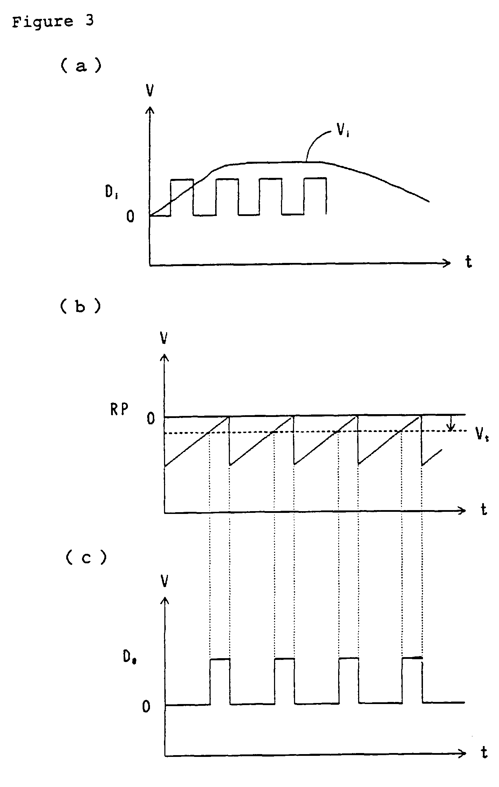

The referential saw-tooth signal "RP" is input to the gate of T1 through capacitance "Cr". The voltage of the gate of T1 is the same as the summation of the electrical charge from C1 to Cn and Cr. Here, the threshold voltage is assumed to be 0V and RP is the saw-tooth wave form in minus with 0V of the maximum value as in Figure 3 (b). When the voltage of the gate is raised by capacitances from C1 to Cn, the effect is generated same as that the threshold for RP becomes lower. It is shown in Figure 3 (b) with broken line Vt. T1 becomes conductive in the part over Vi. The output of T1 is the output pulse signal Do in Figure 3 (c).

As shown in Figure 2, in input module WSi, input pulse signal Di is input to the drain of MOSFET ("T2", hereafter), and the source of T2 is an output terminal of capacitance Ci. The source of T2 is grounded through capacitance Cg2 and resistance R2 in parallel. Charging and discharging electricity on the predetermined time, voltage Vi is generated corresponding to Di. Figure 3 (a) shows an example of the relationship between Di and Vi.

Capacitance Cg3, is connected to the gate of T2 for settling gate voltage, to which MOSFET ("T3", hereafter) is connected for charging electricity. Weight settling pulse signal Wi is input to the gate of T3. Cg3 is charged by power source Vcc during the pulse is in high level, consequently, the voltage of the gate of T2 is settled. The voltage of the gate is equivalent to the weight. The speed for charging Cg2 becomes higher because the voltage between the source and the drain of T2 rises corresponding to the voltage of the gate, consequently, the maximum value of Vi rises. When the drain voltage of T2 is 0V, electricity is discharged from the course to the drain. When the constant is appropriate, R2 is not necessary.

The above description shows that the signal integration circuit changes the voltage of the threshold of T1 according to the duty ratio of the weight input pulse signal Di, and controls the duty ratio of output pulse signal by it. Therefore, it is possible to output the result of weighted pulse input.

As mentioned, the signal integration circuit according to the present invention controls the threshold of MOSFET by voltage integrated by giving electrical charge to a parallel capacitance, generates output pulse signal by eliminating referential saw-tooth wave form with the threshold. Each capacitance is charged by connecting the power source comprising the predetermined voltage to the capacitance synchronous to the input pulse signal. Therefore, it is possible to realize the integration of weighted signal by rather simple circuit.

## Claims

1. A signal integration circuit comprising:
a first MOSFET (T₁) including a drain connected to a power source (V_{cc}) and a gate connected to a plural number of a first capacitances (C₁...CₙCᵣ) in parallel; and
an input means (WS₁...WSₙ) connected to each capacitance;
characterized in that each input means comprises;
a second MOSFET (T₂), the source thereof being connected to said first capacitance through a resistance (R₁), the drain thereof receiving a first input pulse signal (Dᵢ), and the gate thereof being grounded through a second capacitance (Cg₃), and
a third MOSFET (T₃), the source thereof being connected to the gate of said second MOSFET, the drain thereof being connected to a power source (V_{cc}), and the gate thereof receiving a second pulse signal for setting weight;
the gate of said first MOSFET (T₁) receiving a reference saw-tooth signal, the source of said first MOSFET being grounded through a third capacitance (Cg₁), and the output pulse signal (D₀) being output from said source of said first MOSFET (T₁).

## Patentansprüche

1. Signalintegrationsschaltkreis mit:
einem ersten MOSFET (T₁), dessen Drain-Anschluß mit einer Quelle (V_{cc}) verbunden ist und dessen Gate-Anschluß mit einer Vielzahl von parallel zueinander verschalteten ersten Kapazitäten (C₁...CₙCᵣ) verbunden ist, und
einer Eingabeeinrichtung (WS₁...WSₙ), die mit jeder Kapazität verbunden ist;
dadurch gekennnzeichnet, daß jede Eingabeeinrichtung aufweist:
einen zweiten MOSFET (T₂), dessen Source-Anschluß mit der ersten Kapazität über einen Widerstand (R₁) verbunden ist, dessen Drain-Anschluß ein erstes Eingangssignal (Dᵢ) empfängt und dessen Gate-Anschluß über eine zweite Kapazität geerdet ist, und
einen dritten MOSEFT (T₃), dessen Source-Anschluß mit dem Gate-Anschluß des zweiten MOSFET verbunden ist, dessen Drain-Anschluß mit einer Leistungsquelle verbunden ist und dessen Gate-Anschluß ein zweites Pulssignal empfängt, um ein Gewicht einzustellen,
wobei der Gate-Anschluß des ersten MOSFET (T₁) ein Referenz-Sägezahnsignal empfängt, der Source-Anschluß des ersten MOSFETs über eine dritte Kapazität (C_{g1}) geerdet ist und das Ausgangspulssignal (D₀) von dem Source-Anschluß des ersten MOSFET (T₁) ausgegeben wird.

## Revendications

1. Circuit d'intégration de signaux comportant :
un premier MOSFET (T1) comprenant un drain connecté à une source de puissance (Vcc) et une grille connectée à une pluralité de premières capacités (C1 ... Cn, Cr) en parallèle ; et
des moyens d'entrée (WS1, ... WSn) connectés à chaque capacité ;
caractérisé en ce que chacun des moyens d'entrée comprend :
un second MOSFET (T2), dont la source est connectée à ladite première capacité à travers une résistance (R1), dont le drain reçoit un premier signal impulsionnel d'entrée (Di) et dont la grille est mise à la masse par une seconde capacité (Cg3), et
un troisième MOSFET (T3), dont la source est connectée à la grille dudit second MOSFET, dont le drain est connecté à une source de puissance (Vcc) et dont la grille reçoit un second signal impulsionnel pour régler le poids ;
la grille dudit premier MOSFET (T1) recevant un signal en dent de scie de référence, la source dudit premier MOSFET étant mise à la masse par une troisième capacité (Cgl) et le signal impulsionnel de sortie (Do) étant sorti de ladite source dudit premier MOSFET (T1).
